# EUROPEAN PATENT APPLICATION

(11) **EP 4 738 705 A1**
(43) Date of publication of application: **06.05.2026**
(21) Application number: 25212785.7
(22) Date of filing: 31.10.2025
(51) Int. Cl.: H03K 17/06, H02H 9/04, H02M 1/32, H02M 3/155, H03K 19/003, H03K 19/0185

(54) **A SWITCHED MODE POWER SUPPLY, SMPS, CIRCUIT HAVING AN ELECTROSTATIC DISCHARGE, ESD, PROTECTION CIRCUIT, AS WELL AS A CORRESPONDING METHOD**

(30) Priority: 31.10.2024 US 202418932814
(71) Applicant: Nexperia B.V., 6534 AB Nijmegen (NL)
(72) Inventor: Olivares, Jairo, Dallas (US); Vera, Alejandro, Dallas (US); Murtaza, Syed Suhail, Dallas (US)
(74) Representative: Pjanovic, Ilija

(57) **Abstract**

A Switched Mode Power Supply, SMPS, circuit, comprising an SMPS comprising a driver and a low-side switch responsible for regulating power flow to an output of said SMPS circuit, wherein said driver is arranged for controlling said low-side switch and wherein said SMPS operates in a second power domain, a level-shifter circuit arranged for translating signals from a first power domain to the second power domain, an ElectroStatic Discharge, ESD, protection circuit arranged for detecting an ESD event and for enabling said low-side switch upon detection of said ESD event, wherein said ESD protection circuit is implemented in said level-shifter circuit and is connected to a voltage supply in said first power domain.

## Description

### Technical field

The present disclosure generally relates to the field of Switched Mode Power Supplies, SMPS, and, more specifically, to an SMPS having an efficient ElectroStatic Discharge, ESD, protection circuit.

### Background

A switched-mode power supply, SMPS, is an electronic power converter that uses a switching regulator to convert electrical power. It is widely used in various applications, including computers, telecommunications, and industrial systems, because of its high efficiency and compact design. Unlike linear power supplies, which operate continuously in their linear region, SMPS works by rapidly switching the load on and off using semiconductor devices like Metal Oxide Semiconductor Field Effect Transistors, MOSFETs, to control the input and output voltage. This high-speed switching allows SMPS to maintain high efficiency while regulating voltage levels for various electronic devices.

In a buck converter, which is a specific type of switched-mode power supply, the design incorporates typically large MOSFETs that alternately conduct current from the input to the output or from ground to the output during each switching cycle. This converter is primarily used to step down a higher input voltage to a lower output voltage by switching at a high frequency. Components such as inductors and capacitors are utilized to smooth out the output voltage. However, the rapid switching involved in this process introduces certain challenges, including electromagnetic interference, EMI, voltage spikes, and susceptibility to electrostatic discharge, ESD, events.

An ESD event occurs when a sudden discharge of static electricity takes place between two objects with differing electrical potentials. Such events can be caused by human contact, handling of sensitive components, or even environmental conditions.

In the context of an SMPS, ESD may pose a risk to the large (power) MOSFETs and other internal circuitry. The voltage buildup between the switch node pin and ground during an ESD event can exceed the rated voltage of the MOSFETs, leading to permanent damage. This failure may manifest as a short circuit or complete breakdown of the MOSFET, which in turn compromises the functionality of the power supply. Additionally, other components like gate drivers, capacitors, and control circuits may also be vulnerable to damage during such events.

To mitigate the risk of ESD in a switched-mode power supply, several protection strategies are commonly implemented. One widely used approach is the incorporation of transient voltage suppression, TVS, diodes. These diodes are designed to clamp high-voltage transients, absorbing the excess energy generated during an ESD event and preventing it from reaching critical components like the MOSFETs. When an ESD event occurs, the TVS diode temporarily switches to a lowresistance state, diverting the transient energy to ground and protecting the sensitive components. Once the event passes, the diode returns to its high-resistance state, allowing normal operation to resume.

Another common technique is the use of snubber circuits, which consist of resistors and capacitors placed across the MOSFETs. Snubber circuits help absorb voltage spikes that occur due to parasitic inductance during switching. Since the rapid current changes during switching can generate voltage spikes across the MOSFETs, these spikes become more pronounced during an ESD event. By absorbing these spikes, snubber circuits ensure that the voltage across the MOSFETs remains within safe limits.

Downsides of the known techniques is that they are either large or cumbersome of not suitable to be implemented on a semiconductor device.

### Summary

It would be advantageous to achieve a Switched Mode Power Supply, SMPS, that has an efficient ElectroStatic Discharge, ESD, protection circuit. It would further be advantageous to achieve a corresponding method.

In a first aspect of the present disclosure, there is provided a Switched Mode Power Supply, SMPS, circuit. The SMPS circuit comprising:
- an SMPS comprising a driver and a low-side switch responsible for regulating power flow to an output of said SMPS circuit, wherein said driver is arranged for controlling said low-side switch and wherein said SMPS operates in a second power domain;
- a level-shifter circuit arranged for translating signals from a first power domain to the second power domain;
- an ElectroStatic Discharge, ESD, protection circuit arranged for detecting an ESD event and for enabling said low-side switch upon detection of said ESD event, wherein said ESD protection circuit is implemented in said level-shifter circuit and is connected to a voltage supply in said first power domain.

In the SMPS circuit, a level-shifter circuit is used to interface between the two power domains that operate at different, or the same, voltage levels. Its primary function is to translate the voltage level of signals from the first power domain to a compatible voltage level for the second power domain, ensuring that both sides of the circuit can communicate properly. The level-shifter circuit enables the transfer of control signals between circuits operating at these different voltage levels without compromising signal integrity.

The control signals in one part of the SMPS circuit might be generated in an analogue power domain, while the SMPS part, which handles the high-power switching, operates in a power domain. The level-shifter circuit is then arranged to adapt the control signals in the analogue domain to the power domain, allowing the driver to switch the MOSFETs efficiently and safely. This avoids issues such as signal distortion or improper switching that could arise if the voltage levels were not properly matched.

By using a level shifter in this way, the SMPS can maintain compatibility across different power domains.

The inventors have found that it may be beneficial to implement the ESD protection circuit in the level-shifter circuit, wherein the ESD protection circuit is referenced to a voltage supply in the first power domain.

One of the advantages hereof is that during an ESD strike, for example at the switching pin of the SMPS, the voltage at the second power domain will rise quickly. This due to, for example, coupling from the drain to the gate of the low-side switch. The voltage at the second power domain may thus increase significantly, and instantaneously, during the ESD event.

However, the voltage at the first power domain will not get affected. The ESD protection circuit may use the relative stable voltage at the first power domain for detection of the ESD event.

More specifically, a switch may be used in the ESD protection circuit, wherein the switch is connected to a reference voltage in the first power domain and a voltage, for example the supply voltage, in the second power domain. During an ESD event, the reference voltage in the first power domain may not be affected while the voltage in the second power domain may encounter a sudden spike. The difference between these voltage may be used to control this switch for enabling the low-side switch of the SMPS to start conducting. This shunts the ESD current to ground, i.e. through the channel of the low-side switch.

The first power domain may be an analogue power domain. The second power domain may be the driver power domain, wherein the driver is the driver of the SMPS.

In an example, the ESD protection circuit comprises:
- a Field Effect Transistor, FET, connected in series with a resistor, wherein a gate of said FET is connected to said voltage supply in said first power domain.

The FET may be connected, via a drain of the FET, to a voltage node in the second power domain. The inventors have noted that this voltage node in the second power domain may be affected by the ESD event. For example, this voltage node in the second power domain may increase suddenly while the voltage supply in the first power domain may stay relatively constant.

The effect thereof is that the FET may change its state during the ESD event. For example, in normal operation conditions - without the ESD event taking place - the FET may be turned off and during an ESD event the FET may be turned on. Or vice versa. This concept may be used to control the low-side switch of the SMPS.

In a specific example, the level-shifter circuit comprises a cross-coupled inverter, wherein the ESD protection circuit is connected to an output of the cross-coupled inverter.

For example, the drain of the FET may be connected to the output of the cross-coupled inverter.

In another example, the ESD protection circuit is connected to a ground corresponding to said first power domain. This may be accomplished by connecting the source of the FET to ground.

In yet another example, the ESD protection circuit is arranged for pulling said output of said cross-coupled inverters to said ground during said ESD event.

In yet another example, the level-shifter circuit is arranged to receive a control signal, in said first power domain, for controlling said low-side switch and for translating said control signal to said second power domain.

The control signal may, for example, be the low-side ON signal. The low-side ON signal is the signal that controls whether the low-side FET is to be turned on or not.

In a further example, the low-side switch is a Field Effect Transistor, FET.

In another example, the SMPS is any of a synchronous buck converter, boost converter, flyback converter.

The present disclosure is especially useful for low-side switches of the SMPS that are connected to the switching node of the SMPS.

The switching node, SW, in a switched-mode power supply, SMPS, is the point where the switch, i.e. the switching transistor, and the power inductor or transformer are connected. This node alternates between high and low voltage as the transistor switches on and off, controlling the energy transfer to the load and regulating output voltage efficiently by reducing power losses.

During the ESD event, a high voltage may be created at this SW node, wherein that high voltage may damage the low-side switch of the SMPS.

It is noted that the switched mode power supply circuit may be fully implemented on a semiconductor die. Alternatively, the SMPS circuit is implemented on a semiconductor die except for the power FETs of the SMPS, for example the low-side FET.

In a second aspect of the present disclosure, there is provided a method of controlling a Switched Mode Power Supply, SMPS, circuit in accordance with any of the previous example. The method comprises the steps of:
- detecting, by said ESD protection circuit, said ESD event, and
- enabling, by said ESD protection circuit upon detection of said ESD event, said low-side switch.

It is noted that the advantages as explained with reference to the first aspect of the present disclosure, being the Switched Mode Power Supply, SMPS, circuit are also applicable to the second aspect of the present disclosure, being the method of controlling such an SMPS.

In an example, the ESD protection circuit comprises:
- a Field Effect Transistor, FET, connected in series with a resistor, wherein a gate of said FET is connected to said voltage supply in said first power domain.

In a further example, the level-shifter circuit comprises a cross-coupled inverter, wherein the ESD protection circuit is connected to an output of the cross-coupled inverter.

In yet another example, the ESD protection circuit is connected to a ground corresponding to said first power domain.

In a further example, the ESD protection circuit is arranged for pulling said output of said cross-coupled inverters to said ground during said ESD event.

In another example, the method comprises the steps of:
- receiving, by the level-shifter circuit, a control signal, in said first power domain, and
- translating, by the level-shifter circuit, said received control signal to said second power domain.

In yet another example, the SMPS is any of a buck converter, boost converter, flyback converter

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The above and other aspects of the disclosure will be apparent from and elucidated with reference to the examples described hereinafter.

### Brief description of the figures

Fig. 1 discloses a basic example of a buck converter;
Fig. 2 discloses a schematic illustrating the basic concept of the present disclosure;
Fig. 3 discloses an example of a lever-shifter circuit in accordance with the present disclosure.

### Detailed description

It is noted that in the description of the figures, same reference numerals refer to the same of similar components performing a same of essentially similar function.

A more detailed description is made with reference to particular examples, some of which are illustrated in the appended drawings, such that the features of the present disclosure may be understood in more detail. It is noted that the drawings only illustrate typical examples and are therefore not to be considered to limit the scope of the subject matter of the claims. The drawings are incorporated for facilitating an understanding of the disclosure and are thus not necessarily drawn to scale. Advantages of the subject matter as claimed will become apparent to those skilled in the art upon reading the description in conjunction with the accompanying drawings.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including combinations of features from different embodiments, without departing from the scope of the disclosure.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or" in reference to a list of two or more items, covers all the following interpretations of the word: any of the items in the list, all of the items in the list, and any combination of the items in the list.

These and other changes can be made to the technology considering the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein.

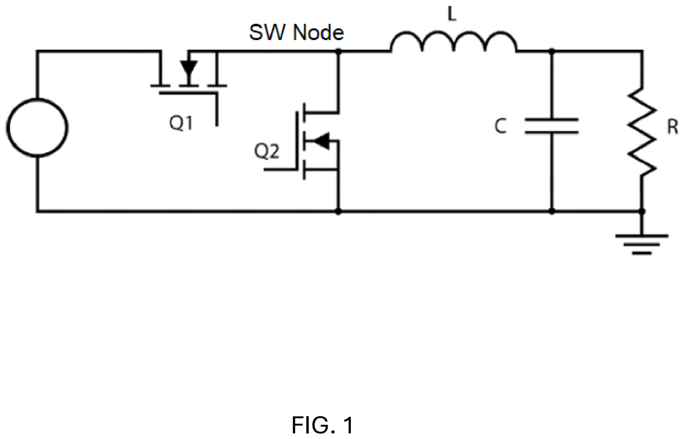

Fig. 1 discloses a basic example of a buck converter.

A buck converter is a type of DC-DC converter that steps down a higher input voltage to a lower output voltage. It operates by switching between two states using a high-side switch (Q1), typically a transistor, and a low-side switch (Q2), either a transistor or diode, controlling the flow of current to regulate the output voltage.

When the high-side switch (Q1) is on, current flows from the input voltage source through the inductor to the load, and the inductor stores energy in its magnetic field. The inductor (L) resists sudden changes in current, which smooths the output and limits the rate at which current increases. At this stage, the output capacitor (C) is charged, providing a stable voltage to the load.

When the high-side switch (Q1) turns off, the low-side switch (Q2) turns on. This allows the inductor (L), which now has stored energy, to continue supplying current to the load. As the current in the inductor decreases, the inductor (L) discharges its energy, preventing sudden drops in current. During this phase, the output capacitor helps to maintain the output voltage by discharging as needed, providing a steady supply of power to the load.

The switching between the high-side (Q1) and low-side (Q2) switches happens at a high frequency, typically tens to hundreds of kHz. This allows for efficient voltage regulation while minimizing power losses. The combination of the inductor, output capacitor, and rapid switching ensures that the output voltage is well-regulated, providing stable power to the load.

The buck converter's efficiency is high because the switches, operating either fully on or fully off, minimize power dissipation, making it ideal for applications where efficient power conversion is of importance. The switching node is indicated with "SW Node". The load is indicated with the reference "R".

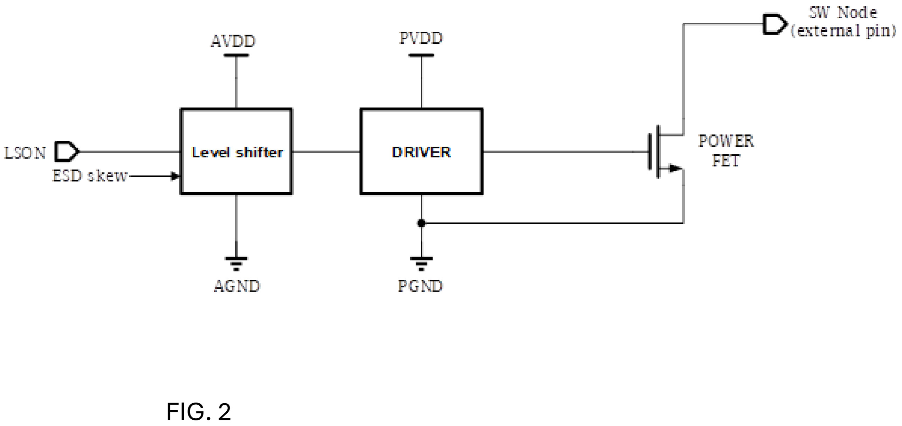

Fig. 2 discloses a schematic illustrating the basic concept of the present disclosure.

Figure 2 shows the overall structure of the SMPS circuit. A level-shifter circuit is implemented and is used to go from the analog power domain (AVDD) and ground domain (AGND) to the driver power domain (PVDD) and ground domain (PGND).

After the level-shifter circuit, the driver circuit may gain up the signal and drive the large power FET, i.e. the low-side switch. A skew is applied in the level-shifter circuit, when an ESD event is detected, the level-shifter circuit will be skewed to turn ON the Large power FET.

It is clear in figure 2 that the ESD protection circuit is implemented in the level-shifter circuit. The ESD protection circuit is connected to both the first power domain and the second power domain. When an ESD event occurs, the second power domain will be affected but the first power domain will not be affected. This will cause a voltage difference between the first and second power domain. This voltage difference is utilized, by the ESD protection circuit, to enable the low-side switch.

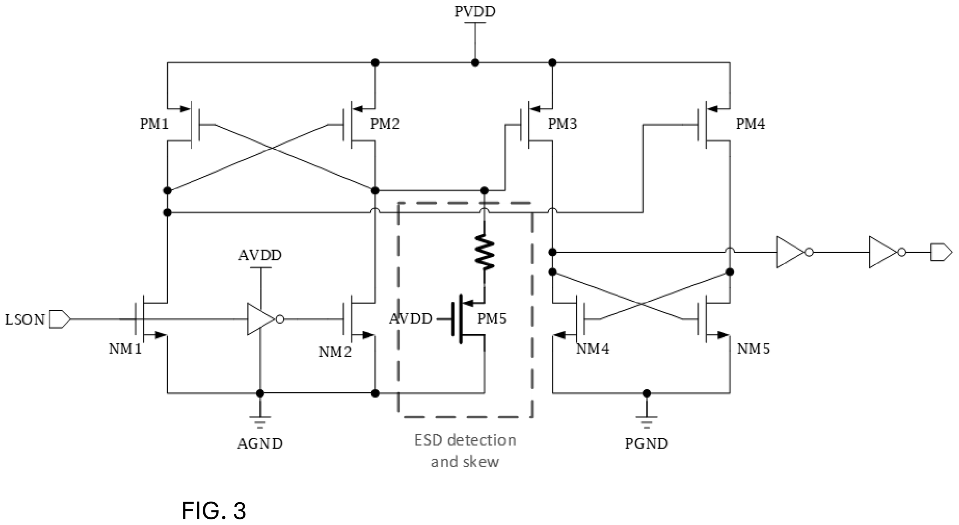

Fig. 3 discloses an example of a lever-shifter circuit in accordance with the present disclosure.

Figure 3 shows a detailed diagram of the level-shifter circuit. The ESD detection circuit is implemented with a transistor, more specifically a PMOS transistor, and a resistor. The resistor is optionally and may also be replaced with a diode or something alike.

The cross-coupled inverter is implemented by the transistors PM1, PM2, NM4 and NM5.

The PMOS transistor of the ESD detection circuit (PM5) has its gate tied to the analog power domain, and the resistor will provide a path from the gate of the transistor PM3 to ground, that is to skew the LSON signal high at the driver. During normal operation, AVDD will be high and PM5 will be turned off. During an ESD strike at the SW pin, the driver power domain, PVDD, will be high due to the coupling from the drain to the gate of the power FET, while AVDD will be low and PM5 will turn on and activate the skewing path in the level shifter.

The output of the level-shifter is provided to the driver of the SMPS which drives the low-side transistor of the SMPS.

As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms.

Accordingly, the actual scope of the technology encompasses not only the disclosed examples, but also all equivalent ways of practicing or implementing the technology under the claims.

## Claims

1. A Switched Mode Power Supply, SMPS, circuit, comprising:
- an SMPS comprising a driver and a low-side switch responsible for regulating power flow to an output of said SMPS circuit, wherein said driver is arranged for controlling said low-side switch and wherein said SMPS operates in a second power domain;
- a level-shifter circuit arranged for translating signals from a first power domain to the second power domain;
- an ElectroStatic Discharge, ESD, protection circuit arranged for detecting an ESD event and for enabling said low-side switch upon detection of said ESD event, wherein said ESD protection circuit is implemented in said level-shifter circuit and is connected to a voltage supply in said first power domain.

2. An SMPS circuit in accordance with claim 1, wherein the ESD protection circuit comprises:
- a Field Effect Transistor, FET, connected in series with a resistor, wherein a gate of said FET is connected to said voltage supply in said first power domain.

3. An SMPS circuit in accordance with claim 2, wherein the level-shifter circuit comprises a cross-coupled inverter, wherein the ESD protection circuit is connected to an output of the cross-coupled inverter.

4. An SMPS circuit in accordance with claim 3, wherein the ESD protection circuit is connected to a ground corresponding to said first power domain.

5. An SMPS circuit in accordance with claim 4, wherein the ESD protection circuit is arranged for pulling said output of said cross-coupled inverters to said ground during said ESD event.

6. An SMPS circuit in accordance with any of the previous claims, wherein the level-shifter circuit is arranged to receive a control signal, in said first power domain, for controlling said low-side switch and for translating said control signal to said second power domain.

7. An SMPS circuit in accordance with any of the previous claims, wherein said low-side switch is a Field Effect Transistor, FET.

8. An SMPS circuit in accordance with any of the previous claims, wherein said SMPS is any of a synchronous buck converter, boost converter, flyback converter.

9. A method of controlling a Switched Mode Power Supply, SMPS, circuit in accordance with any of the previous claims, wherein said method comprises the steps of:
- detecting, by said ESD protection circuit, said ESD event, and
- enabling, by said ESD protection circuit upon detection of said ESD event, said low-side switch.

10. A method in accordance with claim 9, wherein the ESD protection circuit comprises:
- a Field Effect Transistor, FET, connected in series with a resistor, wherein a gate of said FET is connected to said voltage supply in said first power domain.

11. A method in accordance with claim 10, wherein the level-shifter circuit comprises a cross-coupled inverter, wherein the ESD protection circuit is connected to an output of the cross-coupled inverter.

12. A method in accordance with claim 11, wherein the ESD protection circuit is connected to a ground corresponding to said first power domain.

13. A method in accordance with claim 12, wherein the ESD protection circuit is arranged for pulling said output of said cross-coupled inverters to said ground during said ESD event.

14. A method in accordance with any of the claims 9 - 13, wherein the method comprises the steps of:
- receiving, by the level-shifter circuit, a control signal, in said first power domain, and
- translating, by the level-shifter circuit, said received control signal to said second power domain.

15. A method in accordance with any of the claims 9 - 14, wherein said SMPS is any of a buck converter, boost converter, flyback converter.
